# EUROPEAN PATENT APPLICATION

(11) **EP 0 828 299 A2**
(43) Date of publication of application: **11.03.1998**
(21) Application number: 97115134.5
(22) Date of filing: 02.09.1997
(51) Int. Cl.: H01L 31/032

(54) **Compound semiconductor and thin film solar cell**

(30) Priority: 04.09.1996 JP 234508/96
(71) Applicant: MATSUSHITA ELECTRIC INDUSTRIAL CO., LTD, Kadoma-shi, Osaka 571 (JP)
(72) Inventor: Wada, Takahiro, Hirakata-shi, Osaka 573 (JP); Nishitani, Mikihiko, Nara-shi, Nara 631 (JP); Kohara, Naoki, Hirakata-shi, Osaka 573 (JP); Negami, Takayuki, Hirakata-shi, Osaka 573-01 (JP)
(74) Representative: Flaccus, Rolf-Dieter, Dr.

(57) **Abstract**

This invention provides a compound semiconductor which can be used for an absorbing layer of a thin-film solar cell. The compound semiconductor is characterized in that it belongs to a I 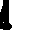 2m space group with a stannic structure and is represented by the formula Cu_{2-3X}(In_{1-Y}Ga_{Y})_{2+X}(Se_{1-Z}S_{Z})₄ (0<X<0.5, 0≦Y≦1, 0≦Z≦0.5). It has a larger band gap than the corresponding compound semiconductor having a chalcopyrite structure.

## Description

This invention relates to a compound semiconductor that may be used for photovoltaic power generation in a thin-film solar cell. More particularly, this invention relates to a compound semiconductor having a specific crystal structure and a thin-film solar cell including the compound semiconductor.

The compounds like CuFeS₂ having a chalcopyrite structure (a pyrite structure) have been known as I- 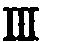 - 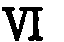 ₂ compounds. A chalcopyrite structure belongs to the tetragonal system and has a unit cell which is two times as large as that of a zincblende structure. The chalcopyrite structure is known to be in the I 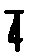 2d space group. Recently, I- 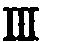 - 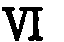 ₂ compounds have attracted considerable attention as a material for a solar cell [A. Rocket and R. W. Birkmire, J. Appl. Phys. vol.70 No.7 p81].

The compound semiconductors having a band gap (Eg) between 1 eV and 1.8 eV can be used for a constituent element of a solar cell, of which CuInSe₂ is typical. The band gap of CuInSe₂ is about 1 eV. This is smaller than 1.4 eV, which is the most suitable value for absorption of the sunlight. Therefore, the band gap of CuInSe₂ was tried to be increased to 1.4 eV to improve the efficiency of a CuInSe₂ solar cell. For enlarging the band gap, CuGaSe₂, which has a larger band gap (Eg=1.68eV), is usually added to make a solid solution with CuInSe₂ (Eg=1eV).

However, although the band gap of the solid solution as shown by the formula of Cu(In₁₋ₚGaₚ)Se₂ (0≦p≦1) is enlarged as Ga is added (as p increases), the conversion efficiency of the solar cell including a thin film of the solid solution is not smoothly increased. After Ga reaches a certain amount, that is, p reaches about 0.2 or 0.3 in the above formula (Eg is about 1.15 eV), the efficiency of the solar cell does not increase and instead tends to decrease [H. W. Schock, MRS BULETIN, vol.18 No.10 pp42-44]. The disorder of the crystal structure of Cu(In₁₋ₚGaₚ)Se₂ is believed to cause the efficiency fall when the larger amounts of Ga are included.

An object of the present invention is to provide a compound semiconductor having a band gap near the most suitable one for the absorption of sunlight and a thin-film solar cell in which such a compound semiconductor is utilized.

The above object of the present invention is achieved in accordance with the present invention by a compound semiconductor having the crystal structure represented by the I 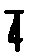 2m space group and the composition represented by the following formula:

Cu_{2-3X}(In_{1-Y}Ga_{Y})_{2+X}(Se_{1-Z}S_{Z})₄ (1),

wherein 0<X<0.5, 0≦Y≦1 and 0≦Z≦0.5.

It is preferable in the compound semiconductor that the crystal structure is a stannite structure. It is also preferable in the compound semiconductor that the crystal structure has the defects located in the position represented by a space group of I 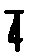 2m. It is preferable that the compound semiconductor is represented by the formula (1), wherein 0.28<X<0.4, 0≦Y≦1 and 0≦Z≦0.5 (more preferably, 0.28<X<0.4, 0.2≦Y≦1 and 0≦Z≦0.5). The compound semiconductor may have the band gap between about 1.25 eV and about 1.9 eV, more preferably between about 1.3 eV and about 1.5 eV.

In accordance with another aspect of the present invention, there is provided a thin-film solar cell comprising a compound semiconductor thin film having the crystal structure represented by the I 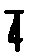 2m space group and represented by the formula (1) as an absorbing layer for the sunlight. This thin-film solar cell may show a higher conversion efficiency, because the compound semiconductor of the present invention has a band gap which is about 0.25 eV larger than that of the corresponding solid solution having a chalcopyrite structure. A mixture of the compound semiconductor and another compound semiconductor like that having a chalcopyrite structure may be used as an absorbing layer.

In accordance with another aspect of the present invention, there is provided a thin-film solar cell comprising a compound semiconductor thin film as a buffer layer and another compound sedmiconductor thin film layer as an absorbing layer, wherein the compound semiconductor in the absorbing layer has a chalcopyrite structure and the compound semiconductor layer in the buffer layer has the crystal structure represented by the I 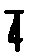 2m space group and the composition represented by the formula (1). This thin-film solar cell may show a higher conversion efficiency, because the compound semiconductor of the present invention in the buffer layer has a similar lattice constant to that of the compound semiconductor in the absorbing layer having a chalcopyrite structure. As the compound semiconductor in the absorbing layer, the compound represented by the following formula can be used.

Cu(In₁₋ₚGaₚ)(Se_{1-q}S_{q})₂ (2),

wherein 0≦p≦1 and 0≦q≦0.5.

This invention can be better understood from the following detailed description when read in conjunction with the drawings.

Fig.1 is an X-ray diffraction pattern of a compound semiconductor of a preferred embodiment of the present invention having the composition Cu_{0.8}In_{2.4}Se₄.

Fig.2 is a tracing of a convergent beam electron diffraction pattern of a compound semiconductor of a preferred embodiment of the present invention having the composition Cu_{0.8}In_{2.4}Se₄, when the electron beam is irradated along the c-axis.

Fig.3 is a schematic perspective view of a stannic structure of a preferred embodiment of the present invention having the composition Cu_{0.8}In_{2.4}Se₄.

### Example 1

The thin film represented by Cu_{0.8}In_{2.4}Se₄ was formed on a substrate composed of soda-lime silica glass by a multi-source vapor deposition method. The composition of the film corresponds to Cu_{2-3X}(In_{1-Y}Ga_{Y})_{2+X}(Se_{1-Z}S_{Z})₄ where X=0.4, Y=0 and Z=0. Each of Cu, In and Se was vaporized from its own source composed of the respective element while the substrate was kept at a temperature of 540 C° . According to the analysis by EPMA (X-ray microanalyser), the obtained thin film was composed of Cu_{0.8}In_{2.4}Se₄, which is the same composition as planned.

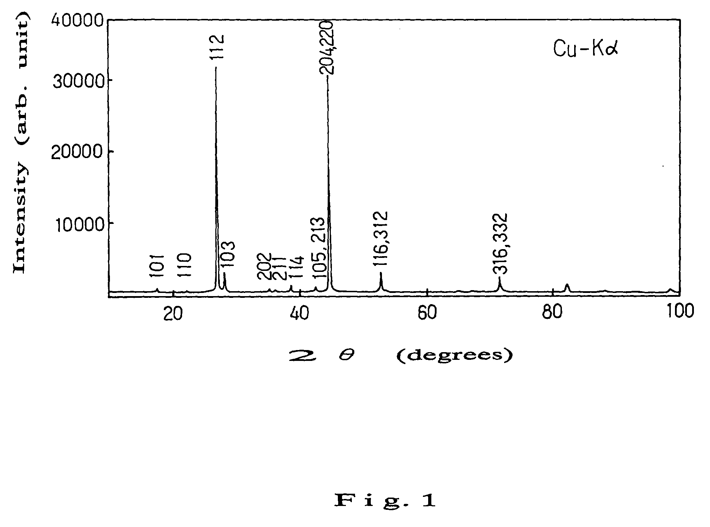

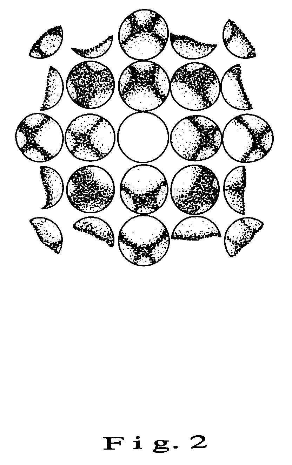

The obtained X-ray diffraction pattern as shown in Fig. 1 (the source of X-ray was Cu) was able to be indexed by the unit cell in the tetragonal system like CuInSe₂ having a chalcopyrite structure. The obtained lattice constants are a=0.5754 nm and c=1.1518 nm. However, the diffraction peaks like 110 and 114, which were not observed in CuInSe₂ having a chalcopyrite structure, were observed as seen in Fig.1. Therefore, the symmetry of the unit cell was investigated by a convergent beam electron diffraction method with a transmission electron microscope (TEM). When the electron beam was irradiated along the c-axis, the convergent beam electron diffraction pattern as shown in Fig.2 was obtained. The diffraction pattern shows the symmetry represented by p4mm. The I 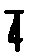 md space group to which a chalcopyrite structure belongs does not show the symmetry represented by p4mm but p4gm, observed along the c-axis.

Analyzing the data of the X-ray diffraction pattern and the convergent beam electron diffraction pattern disclosed that the obtained thin film has a stannic structure and defects located in the position represented by the I 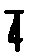 2m space group (No. 121).

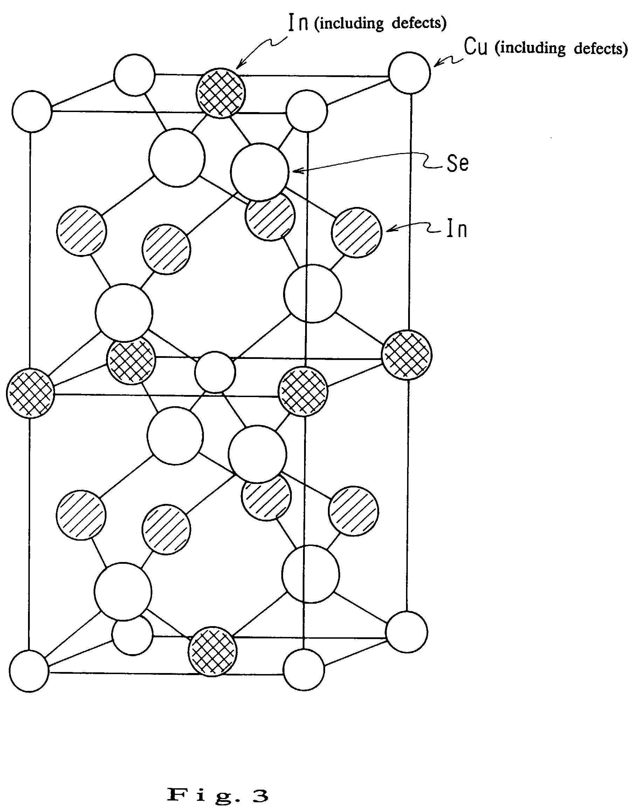

The positions of atoms were confirmed by a Rietveld analysis using X-ray diffraction data as shown in Table 1. The stannic structure of Cu_{0.8}In_{2.4}Se₄ is schematically shown in Fig. 3.

**Table 1**

| The positions of atoms of Cu_{0.8}In_{2.4}Se₄ obtained in Example 1 which has a stannic structure belonging to a space group of I 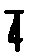 2m (No.121) | | | | | |
|---|---|---|---|---|---|
| Atom | Site of atom | Population | x | y | z |
| Cu | 2a | 0.8 | 0 | 0 | 0 |
| In | 2b | 0.4 | 0 | 0 | 0.5 |
| In | 4d | 1 | 0 | 0.5 | 0.25 |
| Se | 8i | 1 | 0.26 | 0.26 | 0.118 |

The transmittance of the obtained thin film was measured to plot a graph which has an x-axis of photon energy (hν) and a y-axis of (αhν)². The intercept of the x-axis showed that the band gap of the compound semiconductor was 1.26 eV, that is, about 0.25 eV larger than that of the corresponding compound CuInSe₂ having a chalcopyrite structure.

### Example 2

The thin film represented by Cu_{0.8}(In_{0.8}Ga_{0.2})_{2.4}Se₄ was formed on the substrate by a multi-source vapor deposition method. The composition of the thin film corresponds to Cu_{2-3X}(In_{1-Y}Ga_{Y})_{2+X}(Se_{1-Z}S_{Z})₄ where X=0.4, Y=0.2 and Z=0. After a Mo film at a thickness of about 1µm was formed on a substrate composed of soda-lime silica glass, a Li₂O₂ film at a thickness of 50 nm was formed on the Mo film. Each of Cu, In, Ga and Se was vaporized from its own source composed of the respective element while the substrate was kept at a temperature of 550 C°. The analysis with a transmission electron microscope and by an X-ray diffraction method identified the crystal structure of the obtained thin film as a stannic structure.

A thin-film solar cell having a layer structure of MgF₂/ITO/ZnO/CdS/CIGS/Mo/glass was prepared, which includes the Cu_{0.8}(In_{0.8}Ga_{0.2})_{2.4}Se₄ thin film (CIGS thin film) obtained in Example 2 as an absorbing layer. The CdS thin film was formed by a chemical deposition method at a thickness of 50 nm, while the ZnO thin film and the ITO thin film were formed by a sputtering method at a thickness of 0.1 µm. The MgF₂ film as an antireflection layer was formed by an electron beam vapor deposition method at a thickness of about 0.1 µm. The observed conversion efficiency of the solar cell was 17.3% (V_{oc}=0.74 V, J_{sc}=30.8 A/cm², FF=0.76) under the condition of AM=1.5 and 100 mW/cm². The measurement of the spectral sensitivity of the solar cell showed the long wave sensitivity different from that of a solar cell including a Cu(In_{0.8}Ga_{0.2})Se₂ having a chalcopyrite structure as an absorption layer, which made it obvious that the band gap of Cu_{0.8}(In_{0.8}Ga_{0.2})_{2.4}Se₄ was about 0.25 eV larger than that of Cu(In_{0.8}Ga_{0.2})Se₂.

### Example 3

The thin films represented by Cu_{2-3X}(In_{1-Y}Ga_{Y})_{2+X}(Se_{1-Z}S_{Z})₄ specifically shown in Table 2 were formed on a substrate composed of soda-lime silica glass by a multi-source vapor deposition method. Each of Cu, In, Ga and Se was vaporized from its own source composed of the respective element. The composition of each film was confirmed by EPMA, while the crystal structure was confirmed by observing with a transmittance electron microscope and a X-ray diffraction method. The band gap was confirmed by the light transmittance in the same way as described in Example 1. The compositions, the types of the crystal structures, and the values of the band gap are shown in Table 2.

**Table 2**

| The compositions, the types of the crystal structures, and the values of the band gap of Cu_{2-3X}(In_{1-Y}Ga_{Y})_{2+X}(Se_{1-Z}S_{Z})₄ obtained in Example 3 | | | | | |
|---|---|---|---|---|---|
| Sample | X | Y | Z | Type of crystal structure | Band gap (eV) |
| 1 | 0 | 0 | 0 | Pyrite | 1.01 |
| 2 | 0.1 | 0 | 0 | Stannite | 1.26 |
| 3 | 0.3 | 0 | 0 | Stannite | 1.26 |
| 4 | 0.4 | 0 | 0 | Stannite | 1.26 |
| 5 | 0.6 | 0 | 0 | (Layer structure) | ― |
| 6 | 0.4 | 0.2 | 0 | Stannite | 1.35 |
| 7 | 0.4 | 0.4 | 0 | Stannite | 1.45 |
| 8 | 0.4 | 0.6 | 0 | Stannite | 1.57 |
| 9 | 0.4 | 1.0 | 0 | Stannite | 1.83 |
| 10 | 0.4 | 0.2 | 0.2 | Stannite | 1.43 |
| 11 | 0.4 | 0.2 | 0.4 | Stannite | 1.50 |
| 12 | 0.4 | 0.2 | 0.6 | (Spinel structure) | ― |

### Example 4

The solid solution thin film represented by Cu(In_{0.8}Ga_{0.2})Se₂ having a chalcopyrite structure was formed on a substrate at a thickness of 2 µm by a multi-source vapor deposition method. The substrate was composed of soda-lime silica glass on which a Mo thin film was formed at a thickness of 1 µm. Each of Cu, In, Ga and Se was vaporized from its own source composed of the respective element while the substrate was kept at a temperature of 550 C° . On the Cu(In_{0.8}Ga_{0.2})Se₂ film, a Cu_{0.8}(In_{0.8}Ga_{0.2})_{2.4}Se₄ thin film having a stannic structure was formed as a buffer layer at a thickness of 20 nm while the substrate was kept at a temperature of 300 C° .

A thin-film solar cell having a layer structure of MgF₂/ITO/ZnO/CdS/CIGS/Cu(In_{0.8}Ga_{0.2})Se₂/Mo/glass was prepared, which includes the Cu_{0.8}(In_{0.8}Ga_{0.2})_{2.4}Se₄ thin film (CIGS thin film) obtained Example 4 as a buffer layer for the Cu_{0.8}(In_{0.8}Ga_{0.2})Se₂ thin film as an absorbing layer. The CdS thin film was formed by a chemical deposition method at a thickness of 20 nm, while the ZnO thin film and the ITO thin film were formed by a sputtering method at a thickness of 0.2 µm. The MgF₂ film as an antireflection layer was formed by an electron beam vapor deposition method at a thickness of about 0.1 µm. The observed conversion efficiency of the solar cell was 16.8% (Voc=0.65 V, Jsc=34.9 A/cm², FF=0.74) under the condition of AM=1.5 and 100 mW/cm².

### Comparative example

A thin-film solar cell having a layer structure of MgF₂/ITO/ZnO/CdS/Cu(In_{0.8}Ga_{0.2})Se₂/Mo/glass was made, which has the same structure as the solar cell as described in Example 4 except that it does not have a CIGS thin film as a buffer layer. Each method in forming thin films was the same as described in Example 4 and each thickness of the film was also the same. The observed conversion efficiency of the solar cell was 7.5% (Voc=0.45 V, Jsc=27.3 A/cm², FF=0.61) in the condition of AM=1.5 and 100 mW/cm².

## Claims

1. A compound semiconductor having a crystal structure represented by the I 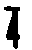 2m space group and a composition represented by the following formula:
Cu_{2-3X}(In_{1-Y}Ga_{Y})_{2+X}(Se_{1-Z}S_{Z})₄,
wherein 0<X<0.5, 0≦Y≦1 and 0≦Z≦0.5.

2. A compound semiconductor according to claim 1, wherein the crystal structure is a stannite structure.

3. A compound semiconductor according to claim 1, wherein the crystal structure has the defects located in the position represented by the 1 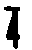 2m space group.

4. A compound semiconductor according to claim 1, wherein the composition is represented by the following formula:
Cu_{2-3X}(In_{1-Y}Ga_{Y})_{2+X}(Se_{1-Z}S_{Z})₄,
wherein 0.28<X<0.4, 0≦Y≦1 and 0≦Z≦0.5.

5. A compound semiconductor according to claim 1, wherein the composition is represented by the following formula:
Cu_{2-3X}(In_{1-Y}Ga_{Y})_{2+X}(Se_{1-Z}S_{Z})₄,
wherein 0.28<X<0.4, 0.2≦Y≦1 and 0≦Z≦0.5.

6. A compound semiconductor according to claim 1, wherein the compound semiconductor has a band gap between 1.25 eV and 1.9 eV.

7. A thin-film solar cell comprising a compound semiconductor thin film as an absorbing layer, wherein the compound semiconductor has the crystal structure represented by the I 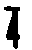 2m space group and a composition represented by the following formula:
Cu_{2-3X}(In_{1-Y}Ga_{Y})_{2+X}(Se_{1-Z}S_{Z})₄,
wherein 0<X<0.5, 0≦Y≦1 and 0≦Z≦0.5.

8. A thin-film solar cell according to claim 7, wherein the crystal structure of the compound semiconductor is a stannite structure.

9. A thin-film solar cell according to claim 7, wherein the crystal structure of the compound semiconductor has the defects located in the position represented by the I 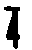 2m space group .

10. A thin-film solar cell according to claim 7, wherein the composition of the compound semiconductor is represented by the following formula:
Cu_{2-3X}(In_{1-Y}Ga_{Y})_{2+X}(Se_{1-Z}S_{Z})₄,
wherein 0.28<X<0.4, 0≦Y≦1 and 0≦Z≦0.5.

11. A thin-film solar cell according to claim 7, wherein the composition of the compound semiconductor is represented by the following formula:
Cu_{2-3X}(In_{1-Y}Ga_{Y})_{2+X}(Se_{1-Z}S_{Z})₄,
wherein 0.28<X<0.4, 0.2≦Y≦1 and 0≦Z≦0.5.

12. A thin-film solar cell according to claim 7, wherein the compound semiconductor has a band gap between 1.25 eV and 1.9 eV.

13. A thin-film solar cell comprising a compound semiconductor thin film composed of a first compound semiconductor and a second compound semiconductor as an absorbing layer, wherein the second compound semiconductor has a chalcopyrite structure and the first compound semiconductor has a crystal structure represented by the I 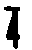 2m space group and a composition represented by the following formula:
Cu_{2-3X}(In_{1-Y}Ga_{Y})_{2+X}(Se_{1-Z}S_{Z})₄,
wherein 0<X<0.5, 0≦Y≦1 and 0≦Z≦0.5.

14. A thin-film solar cell comprising a first compound semiconductor thin film as a buffer layer and a second compound sedmiconductor thin film as an absorbing layer, wherein the second compound semiconductor has a chalcopyrite structure and the first compound semiconductor has a crystal structure represented by the I 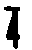 2m space group and a composition represented by the following formula:
Cu_{2-3X}(In_{1-Y}Ga_{Y})_{2+X}(Se_{1-Z}S_{Z})₄,
wherein 0<X<0.5, 0≦Y≦1 and 0≦Z≦0.5.

15. A thin-film solar cell according to claim 14, wherein the crystal structure of the first compound semiconductor is a stannite structure.

16. A thin-film solar cell according to claim 14, wherein the crystal structure of the first compound semiconductor has the defects located in the position represented by the I 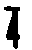 2m space group.

17. A thin-film solar cell according to claim 14, wherein the composition of the first compound semiconductor is represented by the following formula:
Cu_{2-3X}(In_{1-Y}Ga_{Y})_{2+X}(Se_{1-Z}S_{Z})₄,
wherein 0.28<X<0.4, 0≦Y≦1 and 0≦Z≦0.5.

18. A thin-film solar cell according to claim 14, wherein the composition of the first compound semiconductor is represented by the following formula:
Cu_{2-3X}(In_{1-Y}Ga_{Y})_{2+X}(Se_{1-Z}S_{Z})₄,
wherein 0.28<X<0.4, 0.2≦Y≦1 and 0≦Z≦0.5.

19. A thin-film solar cell according to claim 14, wherein the first compound semiconductor has a band gap between 1.25 eV and 1.9 eV.

20. A thin-film solar cell according to claim 14, wherein the composition of the second compound semiconductor is represented by the following formula:
Cu(In₁₋ₚGaₚ)(Se_{1-q}S_{q})₂,
wherein 0≦p≦1 and 0≦q≦0.5.
